# EUROPÄISCHE PATENTSCHRIFT

(11) **EP 1 522 212 B1**
(45) Veröffentlichungstag und Bekanntmachung des Hinweises auf die Patenterteilung: **18.10.2006**
(21) Anmeldenummer: 03763674.3
(22) Anmeldetag: 01.07.2003
(51) Int. Cl.: H05K 7/14

(54) **VORRICHTUNG ZUR MONTAGE-/DEMONTAGE SOWIE FIXIERUNG EINER LEITERPLATINE**
DEVICE FOR ASSEMBLING/DISASSEMBLING AND FIXING A PRINTED CIRCUIT BOARD
DISPOSITIF DE MONTAGE/DEMONTAGE ET DE FIXATION D'UNE CARTE DE CIRCUIT IMPRIME

(30) Priorität: 13.07.2002 DE 10231714
(43) Veröffentlichungstag der Anmeldung: 13.04.2005
(73) Patentinhaber: Smiths Heimann GmbH, 65205 Wiesbaden (DE)
(72) Erfinder: BARTSCHER, Bernd, 65199 Wiesbaden (DE); THOMA, Helmut, 55131 Mainz (DE)
(74) Vertreter: Thul, Hermann
(86) Internationale Anmeldenummer: PCT/EP2003/006967
(87) Internationale Veröffentlichungsnummer: WO 2004/008821

(56) Entgegenhaltungen:
- DE-A- 3 121 967
- DE-U- 7 526 707
- DE-U- 8 508 344

## Beschreibung

### Technisches Gebiet

Die Erfindung betrifft eine Vorrichtung zur Montage-/Demontage und zum Fixieren einer Leiterplatine insbesondere in eine Zeilenhalterung einer Inspektionsanlage.

Bekanntlich ist die Positionierung (Justage) als auch Montage einer Leiterplatine mit Zeilensensoren in einer Zeilenhalterung aufwendig, da die Leiterplatine in einer definierten Position zu einem fächerförmigen Licht- oder Röntgenstrahl räumlich fixiert werden muss. Beim Einbau wird die Leiterplatine über ihre am Rand liegenden Befestigungsbohrungen mit einem in Y - Richtung verschiebbaren vorderen und hinteren Auflageblech mittels Verschraubungen fest verschraubt. Diese Auflagebleche liegen ihrerseits flach auf jeweils einem starr gelagerten vorderen und hinteren, an den Enden abgewinkelten Führungsblech der Zeilenhalterung auf und werden in X - Richtung durch Langlochausstanzungen und Führungsbolzen fixiert. In Z - Richtung erfolgt die Fixierung der vorderen Seite (der Leiterplatinenseite, auf der sich die Sensoren befinden) mittels einer vorerst losen Befestigungsschraube mit mehreren Feder-U-Scheiben, durch die die Leiterplatine gegen ein starres Blech gedrückt wird. Danach wird die hintere, sensorlose Seite durch eine Befestigungsschraube mit einem speziellen Federbronze-Blech-Stanzteil auf ein hinteres, starr gelagertes Auflageblech gedrückt. Auf der vorderen Seite befindet sich eine Justier-Stellschraube, durch die beim Justagevorgang auf das verschiebbare vordere Auflageblech in beiden Y - Richtungen entweder eine Zug- oder eine Druckkraft ausgeübt wird. Nach Abschluss der Feinjustage wird die noch lose Befestigungsschraube mit den Feder-Andruckscheiben festgezogen.

Aus den deutschen Gebrauchsmustern DE 75 26 707 U und DE 85 08 344 U sind Vorrichtungen zum lösbaren Befestigen von Leiterplatinen bekannt, die Trägerteile und Federelemente aufweisen, von denen eine eingebaute Leiterplatte gegen die Trägerteile gedrückt wird. Die vorbekannten Befestigungen haben ausschließlich feststehende Trägerteile und das als Schenkelfeder ausgebildete Federelement drückt ausschließlich in Richtung auf die gegenüberliegend angeordneten Trägerteile. Zur Fixierung der Leiterplatine in dazu senkrechte Richtung sind zusätzliche Haltenasen oder Rastnasen vorgesehen.

### Darstellung der Erfindung

Hier greift die Erfindung die Aufgabe auf, eine Vorrichtung aufzuzeigen, mit der der Montage-/Demontageaufwand für eine Leiterplatine in einer Halterung reduziert wird.

Gelöst wird die Aufgabe durch die Merkmale des Patentanspruchs 1.

Der Erfindung liegt die Idee zugrunde, eines der Trägerteile einer Halterung zur Fixierung einzusparen und dafür eine speziell geformte Feder in die Vorrichtung/Halterung einzubinden. Die Montage (Demontage) einer Leiterplatine vereinfacht sich, da diese nur gegen die Feder und ein feststehendes Trägerteil der Halterung gedrückt werden muß. Um die Leiterplatine u.a. senkrecht gegen das feststehende Trägerteil drücken zu können, ist die speziell ausgebildeten Schenkelfeder unterhalb des feststehenden Trägerteils befestigt. Deren Schenkel ragen beidseitig über die Oberseite des Trägerteils hinaus. Die notwendigen Kräfte zur Montage und Justage werden durch die Feder erzeugt, durch die die Leiterplatine dann in allen drei Richtungen fixiert wird.
In Weiterführung der Erfindung wird eine bauteil- und leiterbahnfreie Auflagefläche der Leiterplatine geschaffen, die als Auflage- und Gleitfläche dient. Das feststehende Trägerteil weist eine definierte Länge auf, so dass es mit ausreichender Länge unter die Leiterplatine ragt.
Die Leiterplatine selbst ist an ihrem Umfang vorzugsweise mit Ausfräsungen oder dergleichen versehen. Zur Führung der Leiterplatine in Y - Richtung ist vorgesehen, dass diese im Bereich ihrer Auflagefläche wenigstens zwei Langlocheinfräsungen besitzt, in die Stifte des feststehenden Trägerteils eingreifen können, wenn die Leiterplatine montiert wird.
Zur Fixierung der Leiterplatine bei der Montage an den gegenüberliegenden anderen Trägerteilen der Halterung, einem feststehenden und zumindest einem dazu bewegbaren Trägerteil, rasten zwei Führungsbolzen oder im Auflageblech schräg aufgebogene Laschen des bewegbaren Trägerteils in weitere Ausfräsungen der Leiterplatine ein.
Die Befestigung des bewegbaren Trägerteils auf dem feststehenden Trägerteils erfolgt mittels Anziehen eines Bolzens des feststehenden Trägerteils, welcher durch ein Langloch im bewegbaren Trägerteil greift.

Die vorgeschlagene Vorrichtung verringert neben der Justagezeit auch bisherige Einbauortstoleranzen. Die Montage als auch eine Demontage der Leiterplatine in die Halterung erfolgt ohne Werkzeug. Trotzdem ist die Leiterplatine mit höherer Genauigkeit und spielfrei fixierbar.

### Kurze Beschreibung der Zeichnung

Anhand einer Ausführungsbeispieles mit Zeichnung soll die Erfindung näher erläutert werden.

Es zeigt
- Fig. 1: eine Draufsichtdarstellung der Vorrichtung mit einer Leiterplatiene in einer Halterung,
- Fig.2: in einer Seitendarstellung das Einsetzen der Leiterplatine aus Fig. 1 in die Halterung,
- Fig. 2a: eine Variante aus Fig. 2,
- Fig. 3: eine Draufsichtdarstellung der Feder aus Fig. 1,
- Fig. 3a: ein Darstellung der Feder aus Sichtrichtung A in Fig. 3,
- Fig. 3b: eine Teildarstellung der Feder aus Sichtrichtung B in Fig. 3.

### Wege zur Ausführung der Erfindung

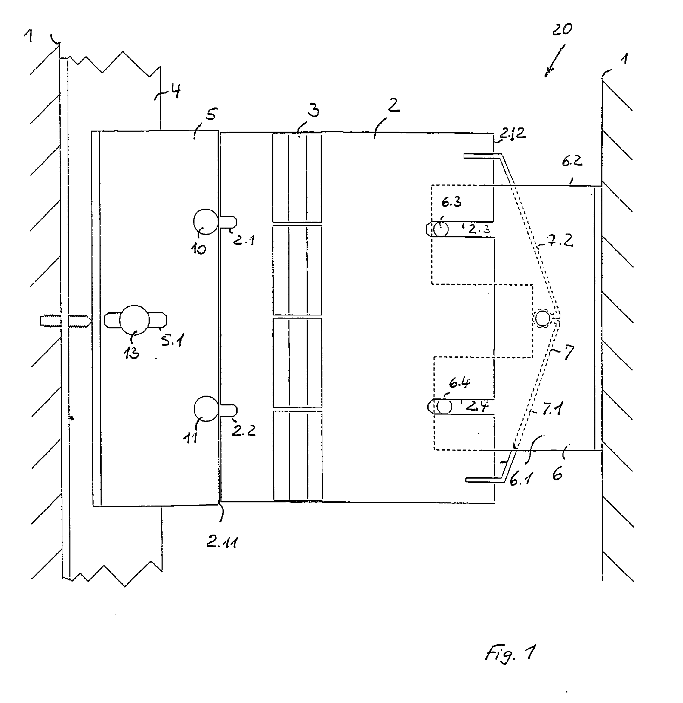

Fig. 1 zeigt eine in einer Zeilenhalterung 1 integrierte Montage-/Demontagevorrichtung 20 einer nicht näher dargestellten lnspektionsanlage mit einer Leiterplatine 2 und darauf befindlichen Zeilensensoren 3 in einer Aufsicht.
Die Vorrichtung 20 weist in dieser Darstellung linksseitig ein an der Halterung 1 feststehendes hinteres Führungsblech 4 sowie ein darauf befindliches vorderes, bewegbares Führungsblech 5 und rechtsseitig ein weiteres an der Halterung 1 feststehendes Führungsblech 6 auf. An der unteren Seite 6.2 des Führungsblechs 6 ist eine Feder 7 als Teil der Montage-/Demontagevorrichtung 20 angebracht, deren Schenkel 7.1 und 7.2 rechts und links über die Oberseite 6.1 der Führungsblechebene hinausragen. Der Befestigungspunkt (Ortes) der Feder 7 wird durch den mittleren, kraftaufnehmenden Punkt bestimmt.

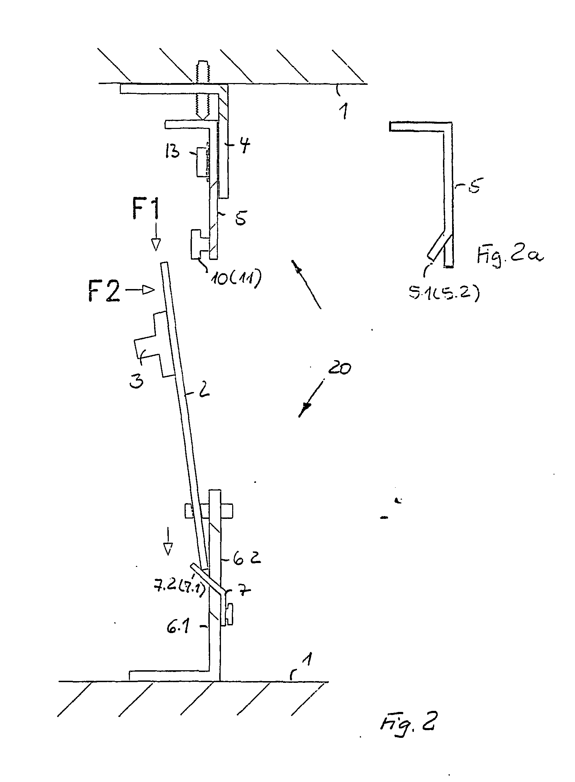

Die Leiterplatine 2 weist eine bauteil- und leiterbahnfreie Auflagefläche auf, die als Auflage- und Gleitfläche dient, und besitzt an in diesem Bereich an ihrer Umfangsseite 2.12 zwei größere U-förmige Ausfräsungen bzw. Führungsnute 2.3, 2.4. Weiterhin sind an der gegenüberliegenden Seite 2.11 zwei kleinere Ausfräsungen 2.1, 2.2 vorgesehen. Die größeren Führungen 2.3, 2.4 wirken mit Führungsstiften 6.3, 6.4 des Führungsblechs 6 , die kleineren Ausfräsungen 2.1, 2.2 mit zwei pilzförmigen Bolzen 10, 11 oder 2 schräg aufgebogene Laschen 5.1, 5.2 (Fig. 2a) des Führungsblechs 5 zusammen.

Das obere Führungsblech 5 weist ein Langloch 5.1 auf, durch welches ein Bolzen 13 des unteren Führungsbleches 4 hindurch reicht und das obere Führungsblech 5 gegenüber dem feststehenden Führungsblech 4 bewegbar lagerbar ist.

Fig. 2 zeigt das Einsetzen der Leiterplatine 2 in die Halterung 1.
Dabei wird die Leiterplatine 2 unterhalb der Federschenkel 7.1, 7.2 jedoch oberhalb des Führungsblechs 6 eingeführt und in Richtung Führungsblech 6 gedrückt, wobei die vom Führungsblech 6 aufragenden Führungsstifte 6.3, 6.4 (oder gestanzten Prägungen) in die Führungsnuten 2.3, 2.4 ein- bzw. durchgreifen. Im so eingebauten Zustand drückt die Leiterplatine 2 permanent in Y - Richtung gegen die beiden abgebogenen Enden der Federschenkeln 7.1, 7.2 und spannt so die Feder 7. Die statische Federkraft drückt ihrerseits die Leiterplatine 2 mit gleicher Gegenkraft in Y - Richtung. Gleichzeitig wird die Leiterplatine 2 mit einer weiteren Kraft, die vorwiegend durch den Anstellwinkel α der Enden der Feder 7 vorgegeben wird, in Z - Richtung, d.h. auf die Oberfläche (obere Seite 6.1) des Führungsblechs 6 gedrückt. Die erforderliche Gegenkraft für die Feder 7 in Z - Richtung wird an den beiden Stellen der unteren Seite 6.2 des Führungsblechs 6 erzeugt, an denen die Federschenkel: 7.1, 7.2 über die Außenkanten hinausragen.

Zur Fixierung der anderen Seite 2.11 der Leiterplatine 2 rasten die auf dem vorderen Führungsblech 5 beiden pilzförmigen Bolzen 10, 11 oder schräg aufgebogenen Blechlaschen 5.1, 5.2 des Führungsblechs 5 in die zwei Ausfräsungen 2.1, 2.2 bei der Montage ein. Mit dem Spannen der Feder 7 und der Fixierung wird die vordere Auflagefläche der Leiterplatiene 2 zunächst in beiden X- und Z- Richtungen fixiert. Durch die gespannte Feder 7 wird die Leiterplatine 2 gleichzeitig jedoch auch iri Y - Richtung gegen die Bolzen 10, 11 (oder schräge Blechlaschen 5.1, 5.2) und somit permanent in dieser Richtung ausgerichtet. Die Justage erfolgt durch Parallelverschiebung der Leiterplatine 2 spielfrei. Die Befestigung des Führungsbleches 5 auf dem Führungsblech 4 erfolgt mittels Anziehen des Bolzens 13.

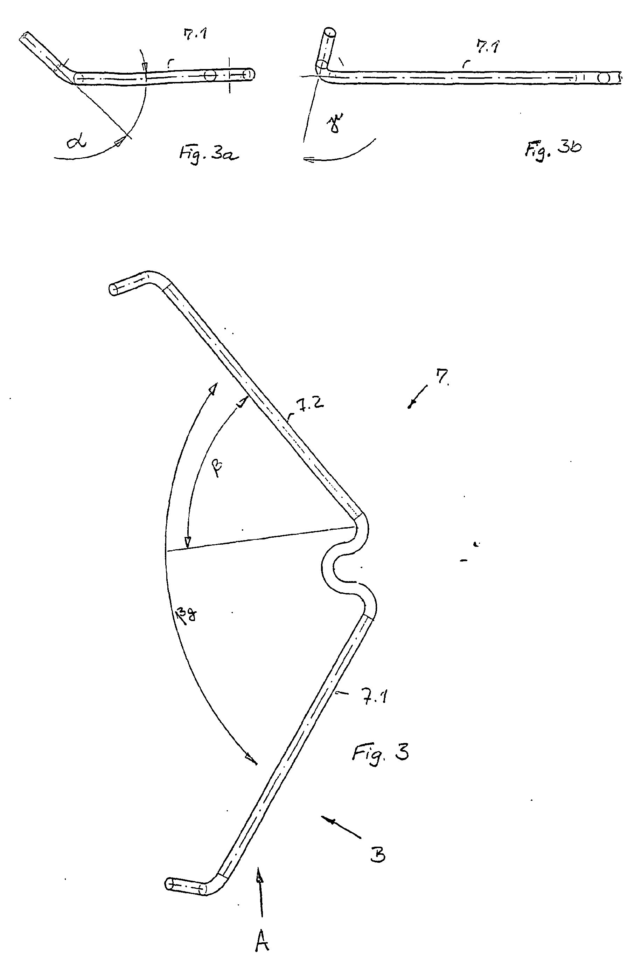

Eine mögliche Ausführung der Feder 7 ist in Fig. 3 dargestellt, wobei in Fig. 3a die Feder 7 aus Sichtrichtung A und Fig. 3b die Feder 7 aus Sichtrichtung B der Feder 7 in Fig. 3 aufgezeigt ist. Die Feder 7 besteht vorzugsweise aus Federstahldraht mit einem Querschnitt von ca. 1,5 mm. In einer bevorzugten Ausgestaltung weisen die Schenkel 7.1, 7.2 eine Spreizwinkel β von je ca. 55° aus. Der Anstellwinkel α der Enden der Feder 7 beträgt ca. 44°, die in sich noch um einen weiteren Winkel χ von ca. 75 ° gebogen sind, wie in Fig. 3b aufgezeigt. Die Länge der beiden, auf die Leiterplatine 2 kraftausübenden Enden der Federschenkel 7.1, 7.2 beträgt vorzugsweise ca. 5 mm.

Durch diese bevorzugte Ausgestaltung und ein definierte Schrägstellung der Federschenkel 7.1, 7.2 zum Führungsblech 6 werden die erforderliche Kräfte erzeugt. Die angegebenen Maße sind selbstverständlich variabel.

Die Vorrichtung ist nicht auf die Montage/Demontage von Leiterplatienen in einer Zeilenhalterung einer Inspektionsanlage beschränkt. Sie kann auch eigenständig unter Einbindung äquivalenter Trägerteile aufgebaut und funktionsfähig sein.

## Patentansprüche

1. Vorrichtung zur Montage-/Demonatge sowie zur Fixierung (1) einer Leiterplatine (2) an zwei gegenüberliegenden Seiten der Leiterplatine, wobei die Vorrichtung zwei Trägerteile umfasst auf denen die Leiterplatine (2) fixiert wird,
- wobei das erste Trägerteil ein feststehendes Trägerteil (4) und ein gegenüber dem feststehenden Trägerteil (4) bewegbar gelagertes weiteres Trägerteil (5) umfasst,
- wobei an der gegenüberliegenden Seite ein zweites Trägerteil (6) mit einem Führungsblech angeordnet ist, an dem eine Schenkelfeder (7) befestigt ist, deren Schenkel (7.1, 7.2) beidseitig über die Oberseite des Führungsblechs hinausragen, so dass die unterhalb der Federschenkel (7.1, 7.2) jedoch oberhalb der Führungsblechebene (6) eingeführte Leiterplatine (2) von der Schenkelfeder (7) sowohl in Richtung auf das bewegbare Trägerteil (5) als auch senkrecht zur Führungsblechebene auf das zweite Trägerteil (6) gedrückt wird.

2. Vorrichtung nach Anspruch 1, **dadurch gekennzeichnet, dass** die Leiterplatine (2) einen Auflagebereich aufweist, der bauteilfrei sowie leiterbahnfrei ist.

3. Vorrichtung nach einem der Ansprüche, **dadurch gekennzeichnet, dass** an der Leiterplatine (2) im Auflagebereich wenigstens zwei Langlöcher (2.3, 2.4) vorgesehen sind, die mit an der Oberseite (6.1) des feststehenden Trägerteils (6) befindlichen Stiften (6.3, 6.4) oder gestanzten Prägungen zusammenwirken.

4. Vorrichtung nach Anspruch 1 oder 2, **dadurch gekennzeichnet, dass** die Leiterplatine (2) an der Seite (2.11) Ausfräsungen (2.1, 2.2) aufweist, in die Führungsbolzen (11, 12) oder schräg aufgebogene Blechlaschen (5.1, 5.2) des bewegbaren oder starren Trägerteils (5) greifen.

5. Vorrichtung nach Anspruch 1 oder 2, **dadurch gekennzeichnet, dass** die Trägerteile (4, 5, 6) Führungsbleche sind.

6. Vorrichtung nach einem der Ansprüche, **dadurch gekennzeichnet, dass** sich auf der dem Auflagebereich zu- oder abgewandten Seite der Leiterplatine (2) Sensoren (3) befinden.

7. Vorrichtung nach einem der Ansprüche, **dadurch gekennzeichnet, dass** die Enden der Federschenkel (7.1, 7.2) einen Anstellwinkel (α) aufweisen.

8. Vorrichtung nach einem der Ansprüche, **dadurch gekennzeichnet, dass** die Federschenkel (7.1, 7.2) je einen Spreizwinkel (β) einschließen.

9. Vorrichtung nach einem der Ansprüche 7 oder 8, **dadurch gekennzeichnet, dass** die Enden der Federschenkel (7.1, 7.2) zusätzlich um einen Winkel (χ) gegenüber dem Anstellwinkel (α) gebogen sind.

10. Vorrichtung nach einem der Ansprüche, **dadurch gekennzeichnet, dass** das Material der Feder (7) Federstahl ist.

11. Vorrichtung nach einem der Ansprüche, **dadurch gekennzeichnet, dass** die feststehenden Trägerteile (4, 6) an einer Zeilenhalterung (1) einer Inspektionsanlage angebracht sind.

## Claims

1. Apparatus for mounting/demounting and for fixing (1) a printed circuit board (2) on two opposite faces of the printed circuit board, with the apparatus comprising two support parts on which the printed circuit board (2) is fixed,
- with the first support part comprising a stationary support part (4) and a further support part (5) which is mounted such that it can move with respect to the stationary support part (4),
- with a second support part (6) with a guide plate being arranged on the opposite side and a leg spring (7) being fixed to the guide plate and the legs (7.1, 7.2) of the said leg spring protruding beyond the upper face of the guide plate on both sides, so that the printed circuit board (2) which is introduced beneath the spring legs (7.1, 7.2) but above the plane (6) of the guide plate is pushed both in the direction of the movable support part (5) and, perpendicular to the plane of the guide plate, in the direction of the second support part (6) by the leg spring (7).

2. Apparatus according to Claim 1, **characterized in that** the printed circuit board (2) has a bearing region which is free of components and conductor tracks.

3. Apparatus according to either of the preceding claims, **characterized in that** at least two elongate holes (2.3, 2.4) are provided in the bearing region on the printed circuit board, these elongate holes interacting with pins (6.3, 6.4) or punched embossed sections which are located on the upper face (6.1) of the stationary support part (6).

4. Apparatus according to Claim 1 or 2, **characterized in that** the printed circuit board (2) has milled-out sections (2.1, 2.2) on the face (2.11), and guide bolts (11, 12) or obliquely bent sheet-metal tabs (5.1, 5.2) of the moveable or rigid support part (5) engage in the said milled-out sections.

5. Apparatus according to Claim 1 or 2, **characterized in that** the support parts (4, 5, 6) are guide plates.

6. Apparatus according to one of the claims, **characterized in that** sensors (3) are located on that face of the printed circuit board (2) which is directed towards or away from the bearing region.

7. Apparatus according to one of the claims, **characterized in that** the ends of the spring legs (7.1, 7.2) have an angle of incidence (α).

8. Apparatus according to one of the claims, **characterized in that** the spring legs (7.1, 7.2) each enclose a spreading angle (β).

9. Apparatus according to either of Claims 7 and 8, **characterized in that** the ends of the spring legs (7.1, 7.2) are additionally bent through an angle (χ) with respect to the angle of incidence (α).

10. Apparatus according to one of the claims, **characterized in that** the material of the spring (7) is spring steel.

11. Apparatus according to one of the claims, **characterized in that** the stationary support parts (4, 6) are attached to a line mount (1) of an inspection facility.

## Revendications

1. Dispositif pour le montage/démontage, ainsi que pour la fixation (1) d'une carte de circuit imprimé (2) sur deux côtés opposés de la carte de circuit imprimé, le dispositif comprenant deux éléments supports, sur lesquels on fixe la carte de circuit imprimé (2),
- le premier élément support comprenant un élément support stationnaire (4) et un élément support supplémentaire (5), monté de façon mobile par rapport à l'élément support stationnaire (4),
- un deuxième élément support (6) avec une tôle de guidage sur lequel est fixé un ressort à branches (7), dont les branches (7.1, 7.2) saillissent bilatéralement par dessus la face supérieure de la tôle de guidage, pour que la carte de circuit imprimé (2) insérée en dessous des branches de ressort (7.1, 7.2), mais toutefois au dessus du plan de la tôle de guidage (6) soit pressée par le ressort à branches (7) aussi bien en direction de l'élément support mobile (5) qu'à la perpendiculaire vers le plan de la tôle de guidage, sur le deuxième élément support (6) étant disposé sur la face opposée.

2. Dispositif selon la revendication 1, **caractérisé en ce que** la carte de circuit imprimé (2) comporte une zone d'appui, qui est exempte de composants et exempte de pistes conductives.

3. Dispositif selon l'une quelconque des revendications, **caractérisé en ce que** dans la zone d'appui, on a prévu sur la carte de circuit imprimé (2) au moins deux trous oblongs (2.3, 2.4) qui interagissent avec des tiges (6.3, 6.4) ou des empreintes estampées sur la face supérieure (6.1) de l'élément support stationnaire (6).

4. Dispositif selon la revendication 1 ou 2, **caractérisé en ce que** la carte de circuit imprimé (2) comporte sur le côté (2.11) des fraisages (2.1, 2.2) dans lesquels s'engagent des boulons de guidage (11, 12) ou des languettes d'acier (5.1, 5.2) recourbées en diagonale de l'élément support mobile ou rigide (5).

5. Dispositif selon la revendication 1 ou 2 **caractérisé en ce que** les éléments supports (4, 5, 6) sont des tôles de guidage.

6. Dispositif selon l'une quelconque des revendications, **caractérisé en ce que** des capteurs (3) se trouvent sur le côté de la carte de circuit imprimé (2) qui fait face ou qui est opposé à la zone d'appui.

7. Dispositif selon l'une quelconque des revendications, **caractérisé en ce que** les extrémités des branches de ressort (7.1, 7.2) ont un angle d'attaque (α).

8. Dispositif selon l'une quelconque des revendications, **caractérisé en ce que** les branches de ressort (7.1, 7.2) incluent chacune un angle d'écartement (β).

9. Dispositif selon l'une quelconque des revendications 7 ou 8, **caractérisé en ce que** les extrémités des branches de ressort (7.1, 7.2) sont recourbées en supplément d'un angle (χ) par rapport à l'angle d'attaque (α).

10. Dispositif selon l'une quelconque des revendications, **caractérisé en ce que** le matériau du ressort (7) est de l'acier à ressort.

11. Dispositif selon l'une quelconque des revendications, **caractérisé en ce que** les éléments supports stationnaires (4, 6) sont montés à une fixation de lignes (1) d'une installation d'inspection.
